# EUROPEAN PATENT APPLICATION

(11) **EP 4 170 721 A1**
(43) Date of publication of application: **26.04.2023**
(21) Application number: 20930648.9
(22) Date of filing: 22.07.2020
(51) Int. Cl.: H01L 27/32, H01L 51/52

(54) **DISPLAY PANEL AND MANUFACTURING METHOD THEREFOR**

(30) Priority: 23.06.2020 CN 202010582956
(71) Applicant: Wuhan China Star Optoelectronics Semiconductor Display Technology Co., Ltd., Wuhan, Hubei 430079 (CN)
(72) Inventor: GONG, Wenliang, Wuhan, Hubei 430079 (CN); XIANYU, Wenxu, Wuhan, Hubei 430079 (CN)
(74) Representative: Patentanwälte Olbricht Buchhold Keulertz
(86) International application number: PCT/CN2020/103399
(87) International publication number: WO 2021/258474

(57) **Abstract**

Embodiments of the present application provide a display panel and a fabrication method thereof. The display panel includes an array substrate, a pixel defining layer, an encapsulation layer, and a black matrix. The pixel defining layer is disposed on the array substrate, the pixel defining layer is formed with a plurality of pixel pits, and the plurality of pixel pits have a first predetermined shape. The encapsulation layer is disposed on the pixel defining layer, and the black matrix is disposed on the encapsulation layer. The black matrix is formed with a plurality of color filter pits, the plurality of color filter pits have a second predetermined shape, and the plurality of color filter pits correspond to the plurality of pixel pits.

## Description

### BACKGROUND

### 1. FIELD OF INVENTION

The present application relates to a field of display technology, and more particularly to a display panel and a fabrication method thereof.

### 2. BACKGROUND OF INVENTION

Organic light-emitting diode (OLED) has gradually replaced traditional liquid crystal displays and is widely used in mobile phone screens, computer monitors, and full-color TV, etc. because of its self-luminosity, high brightness, wide viewing angles, high contrasts, flexibility, and low energy consumption. However, a traditional polarizer (POL) itself has characteristics of low transmittance, large thickness, and brittle material, which greatly limit developments of OLED display panels.

At present, in order to solve this problem, a color filter can be formed by inkjet printing technology to replace the polarizer. However, in a process of filling color filter pits with ink, there is a common problem that the ink cannot completely fill the color filter pits, resulting in light leakage in the display panel.

### SUMMARY

In the process of ink filling the color filter pits, there is a common problem that the ink cannot completely fill the color filter pits, which leads to light leakage in the display panel.

The embodiments of the present application provide a display panel and a fabrication method thereof, which can avoid the problem that the ink cannot completely fill color filter pits during the process of ink filling the color filter pits.

In the first aspect, an embodiment of the present application provides a display panel, comprising:
an array substrate;
a pixel defining layer disposed on the array substrate, wherein the pixel defining layer is formed with a plurality of pixel pits, and the plurality of pixel pits have a first predetermined shape;
an encapsulation layer disposed on the pixel defining layer; and
a black matrix disposed on the encapsulation layer, wherein the black matrix is formed with a plurality of color filter pits, and the plurality of color filter pits have a second predetermined shape, and the plurality of color filter pits correspond to the plurality of pixel pits.

In the display panel provided by an embodiment of the present application, the first predetermined shape comprises a circular shape, an oval shape, or a star shape, and the second predetermined shape comprises a circular shape or an oval shape.

In the display panel provided by an embodiment of the present application, the plurality of pixel pits have a pixel structure, and the plurality of pixel structure comprises a red pixel, a green pixel, or a blue pixel, and the red pixel and the blue pixel have the star shape, and the green pixel has the circular or oval shape.

In the display panel provided by an embodiment of the present application, the color filter pits have a color filter structure, the color filter structure comprises a red color filter, a green color filter or a blue color filter, and the red color filter and the blue color filter are circular, and the green color filter is circular or oval.

In the display panel provided by an embodiment of the present application, an area of the blue color filter is larger than an area of the red color filter and an area of the green color filter, and the area of the red color filter is larger than the area of the green color filter.

In the display panel provided by an embodiment of the present application, the color filter structure has a thickness of 1 micron to 3 microns.

In the display panel provided by an embodiment of the present application, a curing temperature for the color filter structure is less than or equal to 100 degrees Celsius.

In the display panel provided by an embodiment of the present application, the green color filter is circular when the green pixel is circular; or
the green color filter is oval when the green pixel is oval.

In the display panel provided by an embodiment of the present application, the display panel further comprises a plurality of pixel electrodes, and the plurality of pixel electrodes are disposed corresponding to the pixel pits; and

In the display panel provided by an embodiment of the present application, a surface of the pixel defining layer is hydrophobic, and a surface of the pixel electrodes is hydrophilic.

In the second aspect, an embodiment of the present application provides a fabrication method of a display panel, comprising:
providing an array substrate;
forming a pixel defining layer on the array substrate and a plurality of pixel pits having a first predetermined shape on the pixel defining layer;
forming an encapsulation layer on the pixel defining layer; and
forming a black matrix on the encapsulation layer and a plurality of color filter pits having a second predetermined shape on the black matrix, wherein the color filter pits correspond to the plurality of pixel pits.

In the fabrication method of a display panel provided by an embodiment of the present application, after forming the pixel pits having the first predetermined shape on the pixel defining layer and forming the encapsulation layer on the pixel defining layer, further comprising:
dropping ink into the plurality of pixel pits having the first predetermined shape by inkjet printing so that the ink is spread in the plurality of pixel pits to form a pixel structure.

In the fabrication method of a display panel provided by an embodiment of the present application, after forming the plurality of color filter pits having the second predetermined shape on the black matrix, further comprising:
dropping ink into the plurality of color filter pits with the second predetermined shape by inkjet printing so that the ink is spread in the plurality of color filter pits to form a color filter structure.

In the fabrication method of a display panel provided by an embodiment of the present application, the first predetermined shape comprises a circular shape, an oval shape, or a star shape, and the second predetermined shape comprises a circular shape or an oval shape.

In the fabrication method of a display panel provided by an embodiment of the present application, the plurality of pixel pits have a pixel structure, and the pixel structure comprises a red pixel, a green pixel, or a blue pixel, and the red pixel and the blue pixel are star-shaped, and the green pixel is circular or oval.

In the fabrication method of a display panel provided by an embodiment of the present application, the plurality of color filter pits have a color filter structure, and the color filter structure comprises a red color filter, a green color filter or a blue color filter, and the red color filter and the blue color filter are circular, and the green color filter is circular or oval.

In the fabrication method of a display panel provided by an embodiment of the present application, an area of the blue color filter is larger than an area of the red color filter and an area of the green color filter, and the area of the red color filter is larger than the area of the green color filter.

In the fabrication method of a display panel provided by an embodiment of the present application, the green color filter is circular when the green pixel is circular; or
the green color filter is oval when the green pixel is oval.

In the fabrication method of a display panel provided by an embodiment of the present application, the display panel further comprises a plurality of pixel electrodes, and the plurality of pixel electrodes correspond to the plurality of pixel pits; and
a surface of the pixel defining layer is hydrophobic, and a surface of the pixel electrodes is hydrophilic.

In the fabrication method of a display panel provided by an embodiment of the present application, a sidewall of the plurality color filter pits is hydrophobic, and a bottom surface of the plurality of color filter pits is hydrophilic.

The display panel provided by an embodiment of the present application comprises an array substrate, a pixel defining layer, an encapsulation layer and a black matrix. The pixel defining layer is disposed on the array substrate, and the pixel defining layer is formed with a plurality of pixel pits, and the plurality of pixel pits have a first predetermined shape. The encapsulation layer is disposed on the pixel defining layer, and the black matrix is disposed on the encapsulation layer. The black matrix is formed with a plurality of color filter pits, and the plurality of color filter pits have a second predetermined shape. The plurality of color filter pits correspond to the plurality of pixel pits. The present solution can solve problems that the ink cannot completely fill the color filter pits in the process of ink filling the color filter pits.

### BRIEF DESCRIPTION OF DRAWINGS

To detailly explain the technical schemes of the embodiments or existing techniques, drawings that are used to illustrate the embodiments or existing techniques are provided. Apparently, the illustrated embodiments are just a part of those of the present disclosure. It is easy for any person having ordinary skill in the art to obtain other drawings without labor for inventiveness.
FIG. 1 is a schematic structural diagram of a display panel provided by an embodiment of the present application.
FIG. 2 is a top view of a pixel defining layer provided by an embodiment of the present application.
FIG. 3 is a top view of a black matrix provided by an embodiment of the present application.
FIG. 4 is another top view of the pixel defining layer provided by an embodiment of the present application.
FIG. 5 is another top view of the black matrix provided by the embodiment of the present application.
FIG. 6 is a schematic flowchart of a fabrication method of a display panel provided by an embodiment of the present application.

### DETAILED DESCRIPTION OF THE PREFERRED EMBODIMENTS

The technical solutions in the embodiments of the present application will be described clearly and completely with reference to the drawings in the embodiments of the present application. Obviously, the described embodiments are only a part of the embodiments of the present application, but not all the embodiments. Based on the embodiments in the present application, all other embodiments obtained by those skilled in the art without making creative work fall within the protection scope of the present application.

A display panel and a fabrication method thereof are provided by embodiments of the present application and will be described in greater detail in the following.

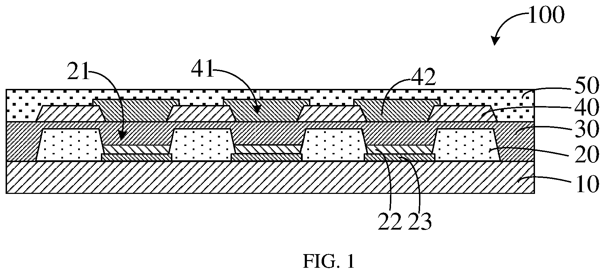

Please refer to FIG. 1. FIG. 1 is a schematic structural diagram of a display panel provided by an embodiment of the present application. The display panel 100 may comprise an array substrate 10, a pixel defining layer 20, an encapsulation layer 30, and a black matrix 40.

Herein, the array substrate 10 may include a plurality of thin film transistors.

Herein, the pixel defining layer 20 is disposed on the array substrate 10. The pixel defining layer 20 is provided with a plurality of pixel pits 21 distributed in an array. It should be noted that the pixel pits 21 have a first predetermined shape. In some embodiments, the first predetermined shape may be a circular shape, an oval shape, or a star shape.

Herein, the encapsulation layer 30 is disposed on the pixel defining layer 20. The encapsulation layer 30 can not only isolate the display panel 100 from an external environment and prevent moisture and oxygen from entering the display panel 100 and affecting a lifespan of the display panel 100, but at the same time, its planar outer surface allows a layer of the black matrix 40 to be fabricated on a flat surface, which is beneficial to display effects of the display panel 100.

Among them, the black matrix 40 is disposed on the encapsulation layer 30. The black matrix 40 is provided with a plurality of color filter pits 41 distributed in an array. It should be noted that the color filter pits 41 have a second predetermined shape. Moreover, the color filter pits 41 correspond to the pixel pits 21. In some embodiments, the second predetermined shape may comprise a circular shape or an oval shape.

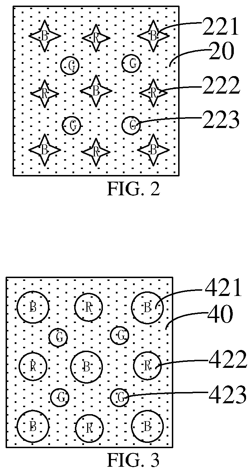

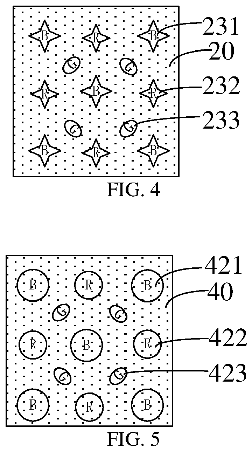

In some embodiments, the pixel pits 21 have a pixel structure 22 therein. Herein, as shown in FIG. 2 or FIG. 4, the pixel structure 22 may include blue pixels 221, red pixels 222, or green pixels 223. It should be noted that the blue pixels 221 and the red pixels 222 may have a star shape. It should be noted that sides of the star shape are arc edges, that is, the star shape is an arc edge star. The green pixels 223 may be circular or oval. It can be understood that the shape of the pixel pit 21 is the same as the shape of the pixel structure 22. That is, the blue pixel pit and the red pixel pit may be a star shape, and the green pixel pit may be circular or oval. It can be understood that a surface area of the blue pixel 221 is larger than a surface area of the red pixel 222 and a surface area of the green pixel 223, and the area of the red pixel 222 is larger than the area of the green pixel 223.

In the embodiment of the present application, since the blue pixel pit and the red pixel pit are a star shape with arc edges, the green pixel pit may be a circular shape or oval shape. The star shape with arc edges, circular shape, or oval shape can effectively reduce a difference in spreading distance of the ink and a difference in an effect of corners and edges of the pixel pit 21 on the ink when the pixel structure 22 is formed by inkjet printing technology, which is beneficial to uniformly spreading of the ink in the pixel pit 21 which improves the light emission uniformity of the pixel structure 22. Therefore, when ink is dropped into the pixel pit 21 having the first predetermined shape by the inkjet printing technology, the ink can be uniformly spread in the pixel pit to form the pixel structure 22.

In some embodiments, the color filter pits 41 have a color filter structure 42 therein. Herein, as shown in FIG. 3 or FIG. 5, the color filter structure 42 may comprise a blue color filter 421, a red color filter 422, or a green color filter 423. Herein, the blue color filter 421 and the red color filter 422 may be a circular shape. The green color filter 422 may be a circular shape or oval shape. It can be understood that the shape of the color filter pits 41 is the same as the shape of the color filter structures 42. That is, the blue color filter pit and the red color filter pit may be a circular shape. The green color filter pit can be circular or oval. It can be understood that an area of the blue color filter 421 is larger than an area of the red color filter 422 and an area of the green color filter 423, and the area of the red color filter 422 is larger than the area of the green color filter 423.

It should be noted that a thickness of the color filter structure 42 may be 1 µm to 3 µm. A curing temperature of the color filter structures 42 is less than or equal to 100 degrees Celsius.

In the embodiment of the present application, the blue color filter pit and the red filter pit are with a circular shape, and the green filter pit may be a circular shape or oval shape. It is understandable that because there are no edge and corners existing in rounded structures of a circular shape or an oval shape, it can effectively reduce the spreading distance difference of ink and the color filter pits when the color filter structure 42 is formed by inkjet printing process. The difference in the effect of the corners and edges on the ink is beneficial to the uniform spread of the ink in the color filter pits 41. Therefore, when ink is dropped into the color filter pits 41 having the second predetermined shape through the inkjet printing process, the ink can be uniformly spread in the pixel pits to form the color filter structures 42.

It is understandable that the color filter structures 42 can filter emitted light to improve color purity of the emitted light. On the other hand, the color filter structures 42 can filter external light, which can reduce entry of ambient light into the display panel 100, thereby reducing reflection of the ambient light by the display panel 100 and improving user experience.

It can be understood that the blue pixel 221 corresponds to the blue color filter 421, the red pixel 222 corresponds to the red color filter 422, and the green pixel 223 corresponds to the green color filter 423.

In order to prevent the formation of the black matrix 40 from causing adverse effects to the optical characteristics of the pixel structure 21, the shape of the pixel pit 21 needs to be matched with the shape of the color filter pit 41 to achieve the best display effect of the display panel 100. In some embodiments, as shown in FIGs. 2 to 3, when the green pixel 223 is a circular shape, the green color filter 423 is a circular shape. As shown in FIGs. 4 to 5, when the green pixel 223 is an oval, the green color filter 423 is an oval.

In some embodiments, the display panel 100 may further comprise a pixel electrode 23. Herein, the pixel electrode 23 is arranged corresponding to the pixel pit 21.

In order to further enable the ink to spread uniformly when forming the pixel structures 22 and the color filter structures 42 and improve the film uniformity of the pixel structures 22 and the color filter structures 42, in some embodiments, a surface of the pixel defining layer 20 is hydrophobic, and a surface of the pixel electrode 23 is hydrophilic. Sidewalls of the color filter pit 41 is hydrophobic, and a bottom wall of the color filter pit 41 is hydrophilic.

It should be noted that because the surface of the pixel defining layer 20 and the color filter pit 41 is hydrophobic, the ink can smoothly fall on the bottom surface of to the pixel electrode 23 or the color filter pit 41 when the ink drops on the sidewall of the pixel pit 21 or the side wall of the color filter pit 41. In addition, since the bottom surface of the pixel electrode 23 and the color filter pit 41 is hydrophilic, it is therefore possible to prevent formation of a concave liquid surface at a contact surface between the ink and the pixel electrode 23 and a contact surface between the ink and the bottom surface of the color filter pit 41, which facilitates the uniform spread of the ink on the pixel electrode 23 and the color filter pit 41 to form a pixel structure 22 and color filter structure 42 with uniform thicknesses.

In some embodiments, the display panel 100 may further comprise a protection layer 50. The protection layer 50 is disposed on the black matrix 40. The protection layer 50 can fix and protect the black matrix 40 and the color filter structure 42, which can protect the display effect of the display panel 100 and improve the reliability of the display panel 100.

Accordingly, the display panel 100 provided by embodiments of the present application may comprise an array substrate 10, a pixel defining layer 20, an encapsulation layer 30, and a black matrix 40. The pixel defining layer 20 is provided on the array substrate 10, and the pixel defining layer 20 is provided with pixel pits 21 thereon, and the pixel pits 21 have a first predetermined shape. The encapsulation layer 30 is provided on the pixel defining layer 20. The black matrix 40 is provided on the encapsulation layer 30, and the black matrix 40 is provided with color filter pits 41, and the color filter pits 41 have a second predetermined shape. The color filter pits 41 correspond to the pixel pits 21. In the present solution, since the color filter pits 41 are of a circular shape or oval shape so that the color filter pits 41 have no corners, therefore, when the color filter structure 42 is formed in the color filter pit 41, the difference in spreading distance of the ink and the difference in the effect of the corners and edges of the color filter pit 41 on the ink can be effectively reduced, which is beneficial to uniformly spreading the ink in the color filter pit 41. Therefore, the present solution can solve the problem that the ink cannot completely fill the color filter pits during the process of ink filling of the color filter pits.

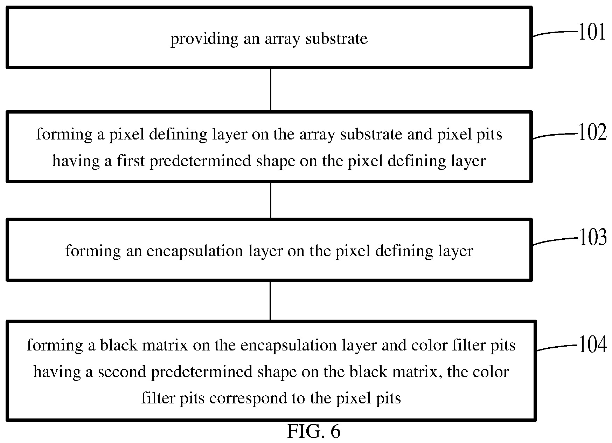

Please refer to FIG. 6, a schematic flowchart of a fabrication method of a display panel according to an embodiment of the present application is provided. The specific process of the fabrication method of the display panel 100 may be as follows:
Step 101: providing an array substrate 10.
Step 102: forming a pixel defining layer 20 on the array substrate 10 and forming pixel pits 21 having a first predetermined shape on the pixel defining layer 20.

The pixel structures 22 may comprise blue pixels 221, red pixels 222, or green pixels 223. It should be noted that the blue pixels 221 and the red pixels 222 may be a star shape. It should be noted that sides of the star shape are arc edges, that is, the star shape is an arc-edged star. The green pixels 223 may be a circular shape or an oval shape. It can be understood that the shape of the pixel pits 21 is the same as the shape of the pixel structures 22. That is, blue pixel pits and red pixel pits may be a star shape, and the green pixel pits may be a circular shape or an oval shape. It can be understood that an area of the blue pixels 221 is larger than an area of the red pixels 222 and an area of the green pixels 223, and the area of the red pixels 222 is larger than the area of the green pixels 223.

Step 103: forming an encapsulation layer 30 on the pixel defining layer 20.

Step 104: forming a black matrix 40 on the encapsulation layer 30 and forming color filter pits 41 having a second predetermined shape disposed on the black matrix 40, and the color filter pits 41 correspond to the pixel pits 21.

The color filter structures 42 may comprise a blue color filter 421, a red color filter 422, or a green color filter 423. Herein, the blue color filter 421 and the red color filter 422 may be a circular shape. The green color filter 422 may be a circular shape or an oval shape. It can be understood that the shape of the color filter pit 41 is the same as the shape of the color filter structure 42. That is, the blue color filter pit and the red color filter pit may be circular. The green color filter pit can be a circular shape or an oval shape. It can be understood that the area of the blue color filter 421 is larger than the area of the red color filter 422 and the area of the green color filter 423, and the area of the red color filter 422 is larger than the area of the green color filter 423.

In some embodiments, after the step of "disposing the pixel pits 21 with the first predetermined shape on the pixel defining layer 20" and before the step of "forming the encapsulation layer 30 on the pixel defining layer 20", the method may further comprise:

dropping ink into the pixel pit 21 having the first predetermined shape by inkjet printing process so that the ink is spread in the pixel pit 21 to form the pixel structure 22.

In some embodiments, after the step of "disposing the color filter pits 41 with the second predetermined shape on the black matrix 40", the method may further comprise:
dropping ink into the color filter pit 41 having the second predetermined shape by inkjet printing process so that the ink is spread in the color filter pit 41 to form a color filter structure 42.

In view of the above, the fabrication method of the display panel provided by the embodiment of the present application provides an array substrate 10. Then, a pixel defining layer 20 is formed on the array substrate 10, and a pixel pit 21 having a first predetermined shape is disposed on the pixel defining layer 20. An encapsulation layer 30 is formed on the pixel defining layer 20. Finally, a black matrix 40 is formed on the encapsulation layer 30, and a color filter pit 41 having a second predetermined shape is formed on the black matrix 40, and the color filter pit 41 corresponds to the pixel pit 21. In the present solution, by forming the color filter pits 41 with the second predetermined shape on the black matrix 40, when the color filter structure 42 is formed in the color filter pit 41 by inkjet printing process, the difference in spreading distance of the ink and the difference in the effects of the corners and edges of the color filter pit 41 on the ink can be effectively reduced , which is beneficial to the uniform spread of the ink in the color filter pit 41. Therefore, the present solution can solve the problem that the ink cannot completely fill the color filter pits in the process of ink filling the color filter pits.

In the above-mentioned embodiments, the description of each embodiment has its own emphasis. For parts that are not described in detail in an embodiment, reference may be made to related descriptions of other embodiments.

The above describes in detail a display panel and a manufacturing method thereof provided by the embodiments of the present application. The descriptions of the above embodiments are only used to help understand the technology of the present application, solutions and their core ideas; those of ordinary skill in the art should understand that they can still modify the technical solutions described in the foregoing embodiments or equivalently replace some of the technical features, and these modifications or replacements do not make the essence of the corresponding technical solutions deviate from the scope of the technical solutions of the embodiments of the present application.

## Claims

1. A display panel, comprising:
an array substrate;
a pixel defining layer disposed on the array substrate, wherein the pixel defining layer is formed with a plurality of pixel pits, and the plurality of pixel pits have a first predetermined shape;
an encapsulation layer disposed on the pixel defining layer; and
a black matrix disposed on the encapsulation layer, wherein the black matrix is formed with a plurality of color filter pits, the plurality of color filter pits have a second predetermined shape, and the plurality of color filter pits correspond to the plurality of pixel pits.

2. The display panel of claim 1, wherein the first predetermined shape comprises a circular shape, an oval shape, or a star shape, and the second predetermined shape comprises a circular shape or an oval shape.

3. The display panel of claim 2, wherein the plurality of pixel pits have a pixel structure, the plurality of pixel structures comprise a red pixel, a green pixel, or a blue pixel, and the red pixel and the blue pixel have the star shape, and the green pixel has the circular or oval shape.

4. The display panel of claim 3, wherein the color filter pits have a color filter structure, the color filter structure comprises a red color filter, a green color filter, or a blue color filter, and the red color filter and the blue color filter are circular, and the green color filter is circular or oval.

5. The display panel of claim 4, wherein an area of the blue color filter is larger than an area of the red color filter and an area of the green color filter, and the area of the red color filter is larger than the area of the green color filter.

6. The display panel of claim 5, wherein the color filter structure has a thickness of 1 micron to 3 microns.

7. The display panel of claim 5, wherein a curing temperature for the color filter structure is less than or equal to 100 degrees Celsius.

8. The display panel of claim 4, wherein the green color filter is circular when the green pixel is circular; or
the green color filter is oval when the green pixel is oval.

9. The display panel of claim 1, wherein the display panel further comprises a plurality of pixel electrodes, and the plurality of pixel electrodes are disposed corresponding to the pixel pits; and
a surface of the pixel defining layer is hydrophobic, and a surface of the pixel electrodes is hydrophilic.

10. The display panel of claim 1, wherein a sidewall of the color filter pits is hydrophobic, and a bottom surface of the color filter pits is hydrophilic.

11. A fabrication method of a display panel, comprising:
providing an array substrate;
forming a pixel defining layer on the array substrate and a plurality of pixel pits having a first predetermined shape on the pixel defining layer;
forming an encapsulation layer on the pixel defining layer; and
forming a black matrix on the encapsulation layer and a plurality of color filter pits having a second predetermined shape on the black matrix, wherein the color filter pits correspond to the plurality of pixel pits.

12. The fabrication method of the display panel according to claim 11, wherein after forming the pixel pits having the first predetermined shape on the pixel defining layer and forming the encapsulation layer on the pixel defining layer, further comprising:
dropping ink into the plurality of pixel pits having the first predetermined shape by inkjet printing so that the ink is spread in the plurality of pixel pits to form a pixel structure.

13. The fabrication method of the display panel according to claim 11, wherein after forming the plurality of color filter pits having the second predetermined shape on the black matrix, further comprising:
dropping ink into the plurality of color filter pits with the second predetermined shape by inkjet printing so that the ink is spread in the plurality of color filter pits to form a color filter structure.

14. The fabrication method of the display panel of claim 11, wherein the first predetermined shape comprises a circular shape, an oval shape, or a star shape, and the second predetermined shape comprises a circular shape or an oval shape.

15. The fabrication method of the display panel according to claim 14, wherein the plurality of pixel pits have a pixel structure, the pixel structure comprises a red pixel, a green pixel, or a blue pixel, and the red pixel and the blue pixel are starshape, and the green pixel is circular or oval.

16. The fabrication method of the display panel according to claim 15, wherein the plurality of color filter pits have a color filter structure, the color filter structure comprises a red color filter, a green color filter, or a blue color filter, and the red color filter and the blue color filter are circular, and the green color filter is circular or oval.

17. The fabrication method of the display panel according to claim 16, wherein an area of the blue color filter is larger than an area of the red color filter and an area of the green color filter, and the area of the red color filter is larger than the area of the green color filter.

18. The fabrication method of the display panel according to claim 16, wherein the green color filter is circular when the green pixel is circular; or
the green color filter is oval when the green pixel is oval.

19. The fabrication method of the display panel of claim 11, wherein the display panel further comprises a plurality of pixel electrodes, and the plurality of pixel electrodes correspond to the plurality of pixel pits; and
a surface of the pixel defining layer is hydrophobic, and a surface of the pixel electrodes is hydrophilic.

20. The fabrication method of the display panel according to claim 11, wherein a sidewall of the plurality color filter pits is hydrophobic, and a bottom surface of the plurality of color filter pits is hydrophilic.
